# EUROPEAN PATENT APPLICATION

(11) **EP 3 517 988 A1**
(43) Date of publication of application: **31.07.2019**
(21) Application number: 18153867.9
(22) Date of filing: 29.01.2018
(51) Int. Cl.: G01R 33/48, G01R 33/54, G01R 33/563, G01R 33/567, G01R 33/561

(54) **MR IMAGING USING A STACK-OF-STARS ACQUISITION WITH INTRINSIC MOTION CORRECTION**

(71) Applicant: Koninklijke Philips N.V., 5656 AE Eindhoven (NL)
(72) Inventor: BECK, Gabriele Marianne, 5656 AE Eindhoven (NL); WUELBERN, Jan Hendrik, 5656 AE Eindhoven (NL); NAGARAJ, Suthambhara, 5656 AE Eindhoven (NL); BAKHRU, Akshay, 5656 AE Eindhoven (NL); KABUS, Sven, 5656 AE Eindhoven (NL)
(74) Representative: de Haan, Poul Erik

(57) **Abstract**

The invention relates to a method of MR imaging of an object (10). It is an object of the invention to enable MR imaging using the stack-of-stars or stack-of-spirals acquisition scheme providing an enhanced image quality in the presence of motion. The method of the invention comprises the steps of:
- generating MR signals by subjecting the object to an imaging sequence comprising RF pulses and switched magnetic field gradients;
- acquiring signal data according to a stack-of-stars or stack-of-spirals scheme, wherein the MR signals are acquired as radial or spiral k-space profiles from a number of parallel slices arranged at adjacent positions along a slice direction, wherein a central portion (20) of k-space is more densely sampled during the acquisition than peripheral portions (21) of k-space;
- reconstructing an intermediate MR image (22-25) from sub-sampled signal data for each of a number of successive time intervals;
- deriving motion induced displacements and/or deformations by registering the intermediate MR images (22-25) with each other; and
- combining the sub-sampled signal data and reconstructing a final MR image therefrom, wherein a motion correction is applied according to the derived motion induced displacements and/or deformations. Moreover, the invention relates to a MR device (1) and to a computer program for a MR device (1).

## Description

### FIELD OF THE INVENTION

The invention relates to the field of magnetic resonance (MR) imaging. It concerns a method of MR imaging of an object placed in the examination volume of a MR device. The invention also relates to a MR device and to a computer program to be run on a MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field Bo whose direction at the same time defines an axis (normally the z-axis) of the co-ordinate system to which the measurement is related. The magnetic field B₀ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the corresponding magnetic field B₁ of this RF pulse extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the magnetization is deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second and shorter time constant T₂ (spin-spin or transverse relaxation time). The transverse magnetization and its variation can be detected by means of receiving RF coils which are arranged and oriented within an examination volume of the MR device in such a manner that the variation of the magnetization is measured in the direction perpendicular to the z-axis. The decay of the transverse magnetization is accompanied by dephasing taking place after RF excitation caused by local magnetic field inhomogeneities facilitating a transition from an ordered state with the same signal phase to a state in which all phase angles are uniformly distributed. The dephasing can be compensated by means of a refocusing RF pulse (for example a 180° pulse). This produces an echo signal (spin echo) in the receiving coils.

In order to realize spatial resolution in the body, time-varying magnetic field gradients extending along the three main axes are superposed on the uniform magnetic field Bo, leading to a linear spatial dependency of the spin resonance frequency. The signal picked up in the receiving coils then contains components of different frequencies which can be associated with different locations in the body. The signal data obtained via the receiving coils correspond to the spatial frequency domain and are called k-space data. The k-space data usually include multiple lines acquired of different phase encoding. Each line is digitized by collecting a number of samples. A set of k-space data is converted to an MR image by means of Fourier transformation.

In the known so-called three-dimensional (3D) stack-of-stars acquisition scheme (see, e.g., WO 2013/159044 A1), a number of spatially non-selective or slab-selective RF excitations is applied, each followed by the acquisition of one or more MR signals (e.g. gradient echo signals), wherein each MR signal represents a k-space profile. The MR signals are acquired as radial k-space profiles from a number of parallel slices. The slices are arranged at different positions along a slice direction in k-space. In the slice direction (e.g. the k_{z}-direction) standard Cartesian phase-encoding is performed, while the MR signals are acquired within each single slice along radial 'spokes' that are rotated around the center (kₓ=k_{y}=0). This results in a cylindrical k-space coverage composed of stacked discs ('stack-of-stars'). Technically, this is realized by generating magnetic field gradients in the in-plane directions of the slices simultaneously and modulating their amplitudes. Different schemes can be used for selecting the temporal order of the k-space profile acquisition steps. E.g., all phase-encoding steps along the slice direction can be acquired sequentially before k-space profiles at different angular positions (rotation angles) are acquired. This ensures that periods of Cartesian sampling are kept short, which leads to high data consistency within the stack of slices and preserves the general motion-robustness of radial sampling for the stack-of-stars approach. The Cartesian phase-encoding steps may be performed from the center slice to the k-space periphery (centric out), or in linear order from -k_{z,max} to +k_{z,max}. For the angular ordering, the imaging sequence can use either equidistant angular sampling with multiple interleaves or the so-called golden angle-scheme. In the equidistant scheme, the angular distance, i.e. the increment of the rotation angle of the radial k-space profiles is calculated according to ΔΦ = 180° / nₜₒₜₐₗ where nₜₒₜₐₗ is the total number of spokes. It may be beneficial to acquire the spokes using multiple interleaves (or 'rotations') because the interleaving reduces temporal coherences in k-space. Thus, motion inconsistencies are spread out in k-space and artifacts are attenuated. In the golden angle-scheme, the rotation angle of the k-space profiles is incremented each time by ΔΦ = 111.25°, which corresponds to 180° multiplied by the golden ratio. Therefore, subsequently sampled spokes always add complementary information while filling the largest gaps within the previously sampled set of spokes. As a consequence, any sequential set of acquired spokes covers k-space approximately uniformly, which, e.g., enables reconstruction of temporal sub-frames and makes the golden-angle scheme well-suited for dynamic (4D) imaging studies.

Similarly, in the also known stack-of-spirals acquisition scheme, each non-selective or slab-selective RF excitation is followed by the acquisition of one or more MR signals that represent spiral k-space profiles. Like in the stack-of-stars method, the slices are also arranged at different positions along a slice direction in k-space, wherein standard Cartesian phase-encoding is performed in the slice direction, while the MR signals are acquired within each single slice along spiral trajectories having their origin in the k-space center (kₓ=k_{y}=0).

The afore-described 3D radial stack-of-stars and stack-of-spirals schemes offer several promising advantages for clinical 3D and 4D MR imaging like high motion-robustness and benign aliasing artifacts.

However, although its motion-robustness, the acquired MR images may still be affected by motion as long as no additional measures for motion compensation are applied.

Motion compensation approaches for stack-of-stars imaging are known in the art.
It has been proposed to use a central k-space profile as an intrinsic navigator for the detection of motion or breathing states (see, e.g., Grimm, R., et al. "Self-gating reconstructions of motion and perfusion for free-breathing T1-weighted DCEMRI of the thorax using 3D stack-of-stars GRE imaging." Proceedings of the 20th scientific meeting, International Society for Magnetic Resonance in Medicine, 2012).

The drawback of such approaches is, however, that they underestimate motion in the radial direction since this direction is not properly encoded. Hence, image quality is hampered in practice by blurring in such intrinsic motion compensation solutions, especially with patients who breathe in the radial direction (so-called AP breathers).

Moreover, gating techniques have been developed accepting only MR signal data acquired within a certain predefined respiratory gating window. To cope with potential drift problems, a multi-gating window approach (referred to as PAWS, see US 7,039,451 B1) has been proposed using a number of individual motion states (bins) rather than one predefined gating window. Each of the motion states corresponds to one of a plurality of contiguous ranges of motion-induced displacements of the body under examination. The final MR image in PAWS is reconstructed from the MR signal data attributed the motion state for which a complete set of MR signal samples is acquired first.

### SUMMARY OF THE INVENTION

From the foregoing it is readily appreciated that there is a need for an improved motion compensation in 3D or 4D stack-of-stars or stack-of-spirals imaging. It is consequently an object of the invention to enable MR imaging using the stack-of-stars or stack-of-spirals acquisition scheme providing an enhanced image quality in the presence of motion.

In accordance with the invention, a method of MR imaging of an object placed in the examination volume of a MR device is disclosed. The method comprises the steps of:
- generating MR signals by subjecting the object to an imaging sequence comprising RF pulses and switched magnetic field gradients;
- acquiring signal data according to a stack-of-stars or stack-of-spirals scheme, wherein the MR signals are acquired as radial or spiral k-space profiles from a number of parallel slices arranged at adjacent positions along a slice direction, wherein a central portion of k-space is more densely sampled during the acquisition than peripheral portions of k-space;
- reconstructing an intermediate MR image from sub-sampled signal data for each of a number of successive time intervals;
- deriving motion induced displacements and/or deformations by registering the intermediate MR images with each other; and
- combining the sub-sampled signal data and reconstructing a final MR image therefrom, wherein a motion correction is applied according to the derived motion induced displacements and/or deformations.

According to the invention, a three-dimensional stack-of-stars or stack-of-spirals acquisition is performed, wherein a central three-dimensional volume of k-space (e.g. a spherical or ellipsoidal volume) is updated more frequently during acquisition than peripheral k-space portions. The central portion of k-space is preferably sampled more closely in time as compared to the peripheral portions. Intermediate MR images are reconstructed from (partially) sub-sampled signal data for each of a number of successive time intervals. The obtained intermediate MR images are then registered with each other. This means, e.g., that one of the intermediate MR images is selected as a reference, wherein each of the other intermediate MR images is registered with the reference image (pair-wise). However, also solutions without the dedicated need for a reference image (group-wise approach) are possible. Per se known (elastic) image registration techniques maybe used for this purpose. Image registration determines a transformation which transforms the different images into one common coordinate system. According to the invention, motion induced displacements and/or deformations are derived from the transformations determined by the registrations of the intermediate images. A final high-resolution MR image is reconstructed according to the invention from the full set of k-space data, i.e. the k-space data acquired over the sequence of time intervals, wherein motion correction is applied according to the derived motion induced displacements and/or deformations. To this end, a correction compensating for the derived displacements and/or deformations is applied to the sub-sampled k-space data acquired during the time interval to which the respective displacements and/or deformations are attributed. The motion-compensated sub-sampled k-space data are then combined and reconstructed into the final MR image which, as a result of the approach of the invention, is essentially free of motion artifacts.

The invention provides a solution to the object of the invention by determining and compensating for motion in all three dimensions. This is achieved by sampling k-space in a variable density fashion over time and by application of (elastic) registration to the central k-space signal data to align different motion states occurring over the full duration of the scan.

The invention enables the intrinsic detection and compensation of motion in all three spatial directions. While the above-mentioned binning methods (e.g. PAWS) restrict the use to repetitive motion (breathing) and motion in the feet head direction, the approach of the invention is generally applicable to all types of motion, independent of the spatial or temporal characteristics.

According to the invention, an intermediate MR image is reconstructed for each time interval from the signal data acquired from the different k-space portions at variable density in the respective time interval. The intermediate MR image is thus generally reconstructed from (partially) sub-sampled signal data. Intermediate MR images can be reconstructed using compressed sensing or a parallel image reconstruction algorithm, such as SENSE or SMASH. The intermediate MR images are then individually corrected according to the derived motion induced displacements and/or deformations attributed to the respective time interval. Finally, the thus corrected intermediate MR images can be combined into the final MR image.

According to the invention, the intermediate motion-corrected MR images can be transformed back to k-space and a k-space weighted image contrast (KWIC) filter (see Song et al., Magn. Reson. Med., 44, 825-832, 2000) and / or compressed sensing can be applied to reconstruct the final MR image of desired relaxation-time weighting.

According to yet another preferred embodiment of the invention, the signal data is weighted in the reconstruction of the final MR image corresponding to the extent of the derived motion induced displacements and/or deformations. For example, the weighting can be derived from a measure of similarity (e.g. cross correlation) of the motion corrected intermediate MR images. The approach of the invention can thus also be used to reduce motion artifacts in the finally reconstructed high-resolution MR image by rejecting motion-corrupted signal data from the reconstruction, if, e.g., the similarity measure is below a given threshold.

The imaging sequence employed by the method of the invention may be, for example, a turbo field echo (TFE) sequence or a balanced (turbo) field echo sequence or an echo planar imaging (EPI) or a turbo spin echo (TSE) sequence or GRASE sequence.

To optimize the k-space distribution of the acquired MR signals, the angular ordering of the radial k-space profiles may be chosen according to a golden angle-scheme. In the golden angle-scheme, as mentioned above, the angle of the k-space profiles is incremented each time by ΔΦ = 111.25° from acquisition to acquisition, which corresponds to 180° multiplied by the golden ratio. Therefore, subsequently sampled radial k-space profiles always add complementary information while filling the largest gaps within the previously sampled set of profiles. As a consequence, any sequential set of acquired profiles covers k-space approximately uniformly.

The distribution of rotation angles can be also adapted to anisotropic field of views (see Wu et al. Al, "Anisotropic field-of-view support for golden angle radial imaging, Magn Reson Med., 76, 229-236, 2016), wherein the radial k-space profiles are not equidistantly distributed. Other methods to improve the temporal footprint capturing the motion state is to influence the sampling order by for example using CENTRA ordering (see WO 2016202707 A1) or the use of Rotated Stack-of-Stars improving the acquisition speed (see Zhou et al., "Golden-ratio rotated stack-of-stars acquisition for improved volumetric MRI", Magn. Reson. Med. 2017). Also a half scan approach may be taken.

The method of the invention described thus far can be carried out by means of a MR device including at least one main magnet coil for generating a uniform, steady magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR device.

The method of the invention can be advantageously carried out on most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a block diagram of a MR device for carrying out the method of the invention;
Fig. 2 schematically illustrates the acquisition and reconstruction scheme of the invention.

### DETAILED DESCRIPTION OF THE EMBODIMENTS

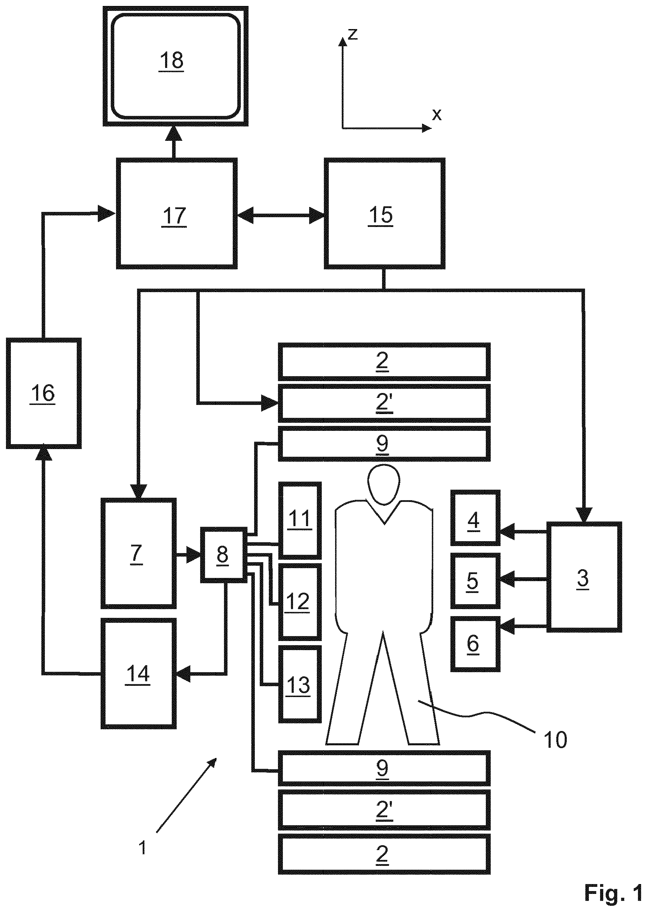

With reference to Fig. 1, a MR device 1 is shown as a block diagram. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient amplifier 3 applies current pulses or waveforms to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance signals. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 or for scan acceleration by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 is programmed to execute the method of the invention described herein above and in the following.

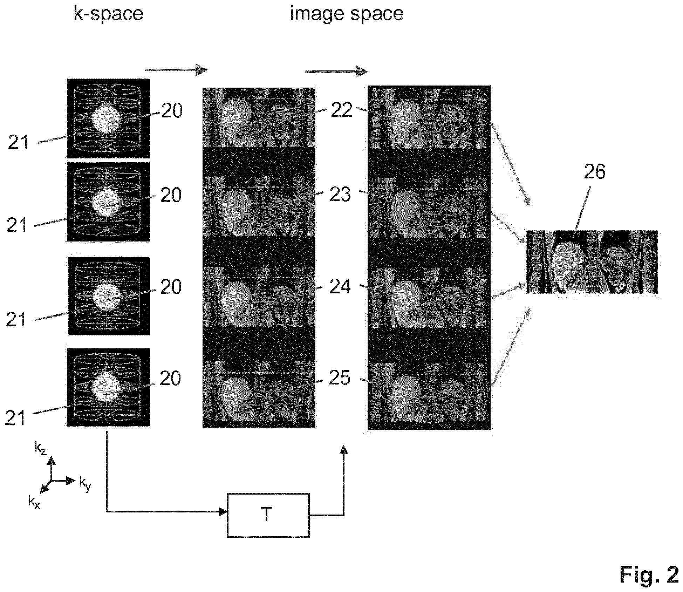

Fig. 2 schematically illustrates an embodiment of the method of the invention. The left column shows sampling of k-space by stack-of-stars imaging in a number of successive time intervals (four in the depicted embodiment) according to the invention. Echo signals are acquired using multi-shot TFE imaging. In each of a number of shots comprising a spatially non-selective or slab-selective RF excitation, a train of echo signals is acquired, wherein each echo signal represents a k-space profile. The echo signals are acquired as radial k-space profiles from a number of parallel k-space slices (five in the depicted embodiment). In an alternative embodiment, the radial k-space profiles may be shifted or rotated for an improved volumetric distribution. The slices are arranged at different positions along slice direction k_{z}. In the k_{z}-direction Cartesian phase-encoding is performed, while the echo signals are acquired within each single slice along radial 'spokes' that are rotated around the center (kₓ=k_{y}=0). This results in a cylindrical k-space coverage composed of stacked discs. A spherical volume is sampled in a variable density fashion, wherein the central region 20 is more frequently updated during the stack-of-stars acquisition than the peripheral k-space portions 21 (Nyquist representation). The four time intervals are selected such that the central volume 20 is fully sampled in each time interval, while the peripheral portions 21 of k-space are undersampled in each time interval. For the angular ordering of the k-space spokes, the golden angle-scheme is employed. The rotation angle of the spokes is incremented from echo signal to echo signal by ΔΦ = 111.25°. Intermediate MR Images 22-25 (second column from the left in Figure 2) are reconstructed from the sub-sampled k-space data for each of the four time intervals (e.g. on a high resolution sampling grid). The four reconstructed intermediate MR images are then registered with each other. An elastic image registration algorithm is used to determine a set of transformations T which transform each of the different intermediate MR images 22-25 into one common coordinate system. The set of transformations T reflects displacements and deformations induced by motion occurring between the time intervals. The set of transformations T is then applied to the intermediate MR images 22-25 to compensate for the occurred motion resulting in motion-corrected intermediate MR images 22-25 (third column from the left in Figure 2). Finally, the corrected intermediate MR images 22-25 are combined into a high-resolution MR image 26 which is essentially free of motion artifacts.

## Claims

1. Method of MR imaging of an object (10) positioned in the examination volume of a MR device (1), the method comprising the steps of:
- generating MR signals by subjecting the object (10) to an imaging sequence comprising RF pulses and switched magnetic field gradients;
- acquiring signal data according to a stack-of-stars or stack-of-spirals scheme, wherein the MR signals are acquired as radial or spiral k-space profiles from a number of parallel slices arranged at adjacent positions along a slice direction, wherein a central portion (20) of k-space is more densely sampled during the acquisition than peripheral portions (21) of k-space;
- reconstructing an intermediate MR image (22-25) from sub-sampled signal data for each of a number of successive time intervals;
- deriving motion induced displacements and/or deformations by registering the intermediate MR images (22-25) with each other; and
- combining the sub-sampled signal data and reconstructing a final MR image therefrom, wherein a motion correction is applied according to the derived motion induced displacements and/or deformations.

2. Method of claim 1, wherein the central portion (20) of k-space is sampled in accordance with the Nyquist criterion while the peripheral portions (21) of k-space are sub-sampled in each time interval.

3. Method of claim 2, wherein the central portion (20) of k-space is sampled more closely in time as compared to the peripheral portions (21).

4. Method of claim 3, wherein the motion corrected intermediate MR images (22-25) are combined either in image space or in k-space into the final MR image (26).

5. Method of any one of claims 1-4, wherein the intermediate MR images (22-25) are reconstructed using a k-space weighted image contrast (KWIC) filter.

6. Method of claim 4 or 5, wherein the intermediate MR images (22-25) are corrected according to the derived motion induced displacements and/or deformations attributed to the respective time interval.

7. Method of any one of claims 1-6, wherein the signal data is weighted in the reconstruction of the final MR image corresponding to the extent of the derived motion induced displacements and/or deformations.

8. Method of claim 7, wherein the weighting is derived from a measure of similarity of the motion corrected intermediate MR images (22-25).

9. Method of any one of claims 1-8, wherein the imaging sequence is a turbo field echo (TFE) or a balanced (turbo) field echo sequence or an echo planar imaging (EPI) sequence or a turbo spin echo (TSE) sequence or a GRASE sequence.

10. Method of any one of claims 1-9, wherein the rotation angle of the radial k-space profiles is incremented according to a golden angle scheme during the acquisition of successive k-space profiles.

11. MR device including at least one main magnet coil (2) for generating a uniform, steady magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR device (1) is arranged to perform the following steps:
- generating MR signals by subjecting the object (10) to an imaging sequence comprising RF pulses and switched magnetic field gradients;
- acquiring signal data according to a stack-of-stars or stack-of-spirals scheme, wherein the MR signals are acquired as radial or spiral k-space profiles from a number of parallel slices arranged at adjacent positions along a slice direction, wherein a central portion (20) of k-space is more densely sampled during the acquisition than peripheral portions (21) of k-space;
- reconstructing an intermediate MR image (22-25) from sub-sampled signal data for each of a number of successive time intervals;
- deriving motion induced displacements and/or deformations by registering the intermediate MR images (22-25) with each other; and
- combining the sub-sampled signal data and reconstructing a final MR image therefrom, wherein a motion correction is applied according to the derived motion induced displacements and/or deformations.

12. Computer program to be run on a MR device, which computer program comprises instructions for:
- generating an imaging sequence comprising RF pulses and switched magnetic field gradients;
- acquiring signal data according to a stack-of-stars or stack-of-spirals scheme, wherein MR signals are acquired as radial or spiral k-space profiles from a number of parallel slices arranged at adjacent positions along a slice direction, wherein a central portion (20) of k-space is more densely sampled during the acquisition than peripheral portions (21) of k-space;
- reconstructing an intermediate MR image (22-25) from sub-sampled signal data for each of a number of successive time intervals;
- deriving motion induced displacements and/or deformations by registering the intermediate MR images (22-25) with each other; and
- combining the sub-sampled signal data and reconstructing a final MR image therefrom, wherein a motion correction is applied according to the derived motion induced displacements and/or deformations.
